Europäisches Patentamt

European Patent Office

Office européen des brevets

(19)

(11) EP 0 582 086 B2

(12) NEW EUROPEAN PATENT SPECIFICATION

(45) Date of publication and mention
of the opposition decision:
**13.01.1999 Bulletin 1999/02**

(51) Int Cl.$^6$: **H05K 13/08**, H01L 21/00

(45) Mention of the grant of the patent:
**22.11.1995 Bulletin 1995/47**

(21) Application number: 93110537.3

(22) Date of filing: **01.07.1993**

(54) **Method for mounting components and an apparatus therefor**

Verfahren zum Montieren von Bauteilen und Vorrichtung dafür

Procédé de montage de composants et dispositif de mise en oeuvre

(84) Designated Contracting States:
**CH DE GB IT LI NL**

(30) Priority: **01.07.1992 JP 174328/92**
**04.08.1992 JP 208284/92**

(43) Date of publication of application:
**09.02.1994 Bulletin 1994/06**

(73) Proprietor: **YAMAHA HATSUDOKI KABUSHIKI KAISHA**
**Iwata-shi Shizuoka-ken, 438 (JP)**

(72) Inventors:
• **Ohta, Hiroyuki**
**Hamamatsu-shi, Sizuoka-ken (JP)**

• **Indo, Kenichi**
**Hamakita-shi, Sizuoka-ken (JP)**
• **Sakurai, Hiroshi**
**Hamamatsu-shi, Sizuoaka-ken (JP)**

(74) Representative: **Grünecker, Kinkeldey,**
**Stockmair & Schwanhäusser Anwaltssozietät**
**Maximilianstrasse 58**
**80538 München (DE)**

(56) References cited:
**EP-A- 0 144 717**    **EP-A- 0 374 848**
**WO-A-92/14988**    **GB-A- 2 183 820**
**US-A- 5 040 291**

EP 0 582 086 B2

## Description

The present invention relates to a method for mounting a component such as a chip component or the like at a specific position, preferably on a substrate such as a printed circuit board, by means of attracting the component by an attracting nozzle from a component supply unit, transferring the component and mounting same at the desired position. Moreover, the present invention relates to a mounting apparatus for mounting such components.

From EP-A-0 144 717, a method according to the preamble of Claim 1 and an apparatus according to the preambles of Claims 3 and 11 are known.

For mounting minute components such as ICs, resistors, condensers, etc., exactly on their specified positions on a substrate, a mounting apparatus was already suggested which attracts a component through an attracting nozzle by vacuum detecting the attracting position of the component in view of irregularities which can prevent the component from being precisely positioned on the desired spot onto the substrate. Moreover, it has been deliberated to try to balance displacements of the attracting point of the component in different directions relative to the centre of the component in order to introduce such data into the control means for precisely positioning the component. Difficulties have arisen in as far as such measurements aiming to acquire correcting values for improving the mounting accuracy considerably increase the cycle time of the assembling procedure, lowering the efficiency of the mounting procedure.

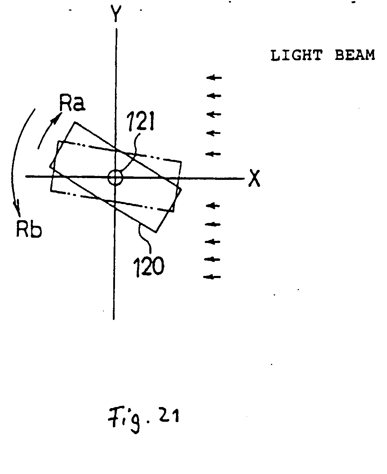

More specifically, it has been deliberated to acquire said correcting values by detecting a projection width of the component while, after preliminarily rotating the component about the attracting point thereof, the component be rotated in a sense opposite to the preliminary rotation which was thought about to securely detect a minimum projection width of the component assuring a proper detecting position and condition of same. Alternatively, it might be preferred to design a component mounting apparatus adapted for attracting a chip component from a component feeding section such as a tape feeder etc., by a component mounting head unit equipped with an attracting nozzle, transferring the component to the substrate disposed in a predetermined position and mounting the component at the specified position on the substrate. Considering that the correcting amounts could be determined on the basis of a projection of the component subject to parallel light beams and rotated in said position as shown in Fig. 21 and in order to securely detect a minimum projection width of the component, the attracting nozzle having said component attracted thereto could be rotated by a definite angle in a predetermined positive direction (counterclockwise in Fig. 21) while the component 120 is irradiated with parallel rays in X-axis direction detecting the projection width of the component in direction of a Y-axis during the rotation. Some basic parameters of the component could be detected in the state of minimum projection width (state in which in a longer or shorter side of the component is in parallel with the X-axis) and the correcting amount could be obtained on the basis of this data.

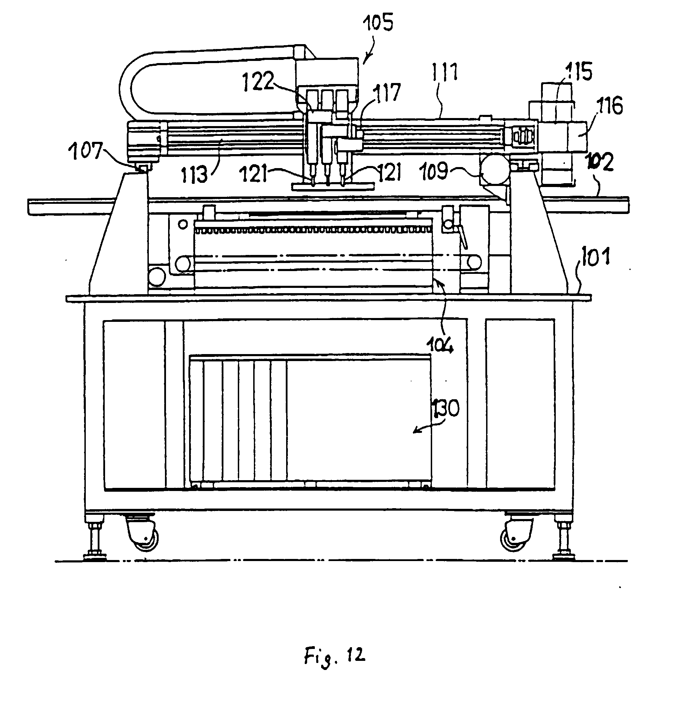

However, in case of the first alternative, the requirement for a preliminary rotation prolongates the detecting time which is waste time in terms of the assembling process and, therefore, lowers the efficiency of the component mounting procedure, whereas also in case of the second alternative it is unknown whether the component is inclined in a positive direction or negative direction (as the orientation the component is attracted to the attracting nozzle is scattering around the direction of the X-axis within a predetermined range of angle of rotation) and the rotation of the component in a positive direction by a definite angle only might not reliably lead to the state of characterstic projection such as minimum projection width. Thus, also in that case it has been deliberated to make the component rotate surely through the state of minimum projection width by firstly rotating it in the negative direction ($\rightarrow$ Ra in Fig. 21) by a certain angle $\theta_s$ and then rotating the component in the positive direction ($\rightarrow$ Rb in Fig. 12).

Accordingly, it is an objective of the present invention to provide a method of the type as indicated above enabling to reduce the time necessary for detecting a projection width of the component and, therefore, to increase the efficiency of the component mounting process.

Moreover, it is another objective of the present invention to provide an apparatus for mounting a component at a specific position, preferably on a substrate such as a printed circuit board, comprising a moveable mounting head unit supporting an attracting nozzle for attracting by vacuum a component to be mounted from a component feeding section of a component supply unit, a component position detecting means and a main control unit for controlling the operation of the apparatus which allows reduced cycle times of the mounting procedure to be obtained and to increase the mounting performance of the apparatus.

In order to perform said objectives, according to a first aspect of the present invention a method of the type as indicated above is provided wherein the component, after being attracted by the attracting nozzle, is preliminarily rotated by a certain angle about a vertical axis of the attracting nozzle while simultaneously being raised by said attracting nozzle in the direction of a vertical Z-axis to set the component in a predetermined starting position for further detection of a minimum projection width of the component after same has been moved into a detection area of an optical detecting means.

In this way a preliminary rotation of the component to assure a proper subsequent detection of a projection width thereof is performed simultaneously while the attracting nozzle with the component attracted thereto is being raised so that the time for said preliminary rotation is overlapped to the attracting nozzle raising time which is in any way required to pick up a component and transfer it to a detecting area of the optical detecting means. In this way waste time is minimized and the component mounting efficiency is improved.

According to a preferred embodiment of the present invention in its method aspects, the component is rotated in the detection area of the optical detecting means in a sense opposite to the preperatory preliminary rotation, wherein the projection width of the component is obtained during the rotation of the component in the detection area of the optical detecting means, and correcting amounts for the mounting position of the component are calculated.

In order to perform the objective of the present invention in terms of the apparatus aspects of the present invention, according to a second aspect of the invention, an apparatus for mounting a component at a specific position, preferably on a substrate such as a printed circuit board, comprising a moveable mounting head unit supporting an attracting nozzle for attracting by vacuum a component to be mounted from a component feeding section of a component supply unit, a component position detecting means and a main control unit for controlling the operation of the apparatus for performing the afore-indicated method, wherein said attracting nozzle is supported rotatably about its vertical centre axis and the detecting means is an optical detecting means to provide a projection of the component and to detect the projection width of the component as well as to obtain correcting amounts for the mounting position is characterised in that a preliminary rotation control means is connected to a main processor of the main control unit and in that said main control unit is adapted to preliminary rotate said component after being attracted through said attracting nozzle by a certain angle about the vertical axis of the attracting nozzle while the component is simultaneously raised by said attracting nozzle to said detection means.

Preferably, said main processor is provided for calculating at least one mounting position correcting amount of the component's mounting position in response to the other correcting amounts measured.

Alternatively, according to a third aspect of the present invention, in order to perform the afore-indicated objective in terms of the apparatus aspects of the present invention, an apparatus for mounting a component at a specific position, preferable on a substrate such as a printed circuit board, comprising a moveable mounting head unit supporting at least one attracting nozzle for attracting by vacuum at least one component to be mounted from a component feeding section of a component supply unit, a component position detecting means and a main control unit for controlling the operation of the apparatus, wherein said attracting nozzle is supported rotatably about its vertical centre axis, and the detecting means is an optical detecting means to provide a projection of the component and to detect the projection width thereof as well as to obtain correcting amounts for its mounting position, is characterised in that at least one component feeding section and the optical detecting means are disposed such that a light beam irradiating direction of the optical detecting means defines a predetermined angle of inclination to the direction of the disposition of the components in the component feeding section.

By this apparatus a preparatory preliminary rotation of the component prior to initiating the actual steps of detecting the projection width thereof is completely dispensible as said apparatus comprises the chip component always in a state inclined in the same sense relative to the parallel light beam irradiating direction when it is attracted to the attracting nozzle. Thus, the efficiency of the process is improved as well.

Further preferred embodiments of the present invention are laid down in the further sub-claims.

In the following the present invention is explained in greater detail by means of several embodiments thereof in conjunction with the accompanying drawings wherein:

Figure 1 is an apparatus for mounting a component according to a preferred first embodiment of the present invention in a perspective view,

Figure 2 is a front view of a mounting head unit of the apparatus of Figure 1,

Figure 3 is a block diagram of the components and control means of the apparatus of Figure 1,

Figure 4 is a flow chart showing the method for mounting the component according to a preferred embodiment of the present invention by the apparatus of Figure 1,

Figure 5 is an explanatory table showing the vertical movement (Z-axis) and the rotating movement (R-axis) of the component at each step of the mounting procedure,

Figure 6 is a plan view showing the movement path of the mounting head unit with the attracting nozzle corresponding to the method of Figure 5,

Figures 7a through Figures 7c are explanatory illustrations showing the method for detecting a minimum projection width of the component according to an embodiment of the present invention,

Figure 8 is a diagram showing the change in projection width of the component in response to its angle of rotation,

Figure 9 is an explanatory illustration for deriving the equations of calculation of the correcting amount $X_c$ for the X-axis direction,

Figures 10a through 10c are illustrations showing various (normal and irregular) attracting conditions of the component,

Figure 11 is a plan view of a component mounting apparatus according to another embodiment of the present invention,

Figure 12 is a front view of the mounting apparatus of Figure 11,

Figure 13 is an enlarge front view of a mounting head unit of the apparatus of Figure 11,

Figure 14 is a block diagram of the components and control means of the apparatus of Figure 11,

Figures 15a through 15e are explanatory illustrations showing a series of sequential attracting and mounting operations similar to that of Figure 5 for the first embodiment,

Figure 16 is an explanatory illustration showing schematically a component in its condition attracted to an attracting nozzle of the mounting head unit,

Figure 17 is an explanatory illustration of the state of the component rotated as a process for obtaining a correcting amount for the mounting position of the component,

Figure 18 is an explanatory illustration for deriving the equations of calculation of the correcting amount $X_c$ for the X-axis direction, similar to Figure 9.

Figure 19 is a plan view similar to that of Figure 11 showing a component mounting apparatus according to a third embodiment of the present invention,

Figure 20 is a plan view similar to that of Figure 18, showing a component mounting apparatus according to a fourth embodiment of the present invention, and

Figure 21 is an explanatory illustration showing difficulties to be overcome by the method and apparatus according to the present invention.

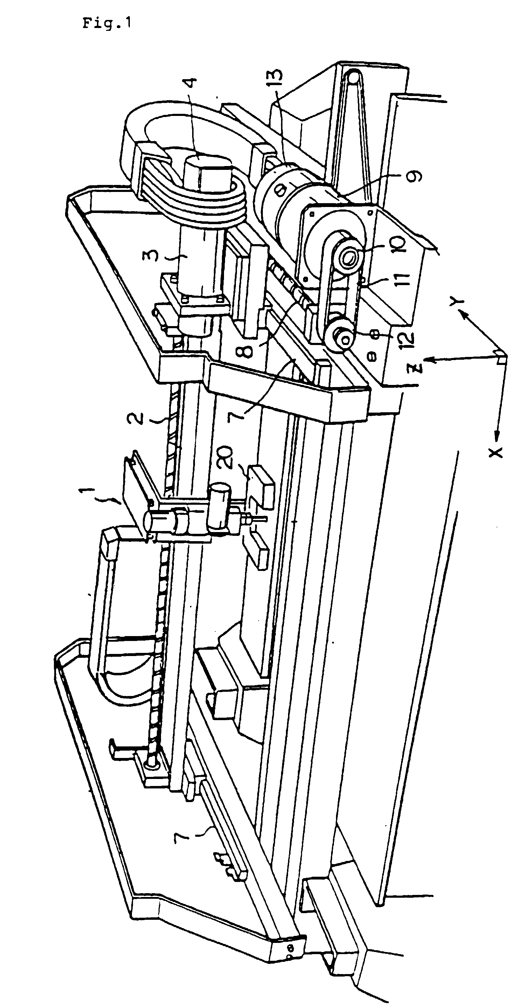

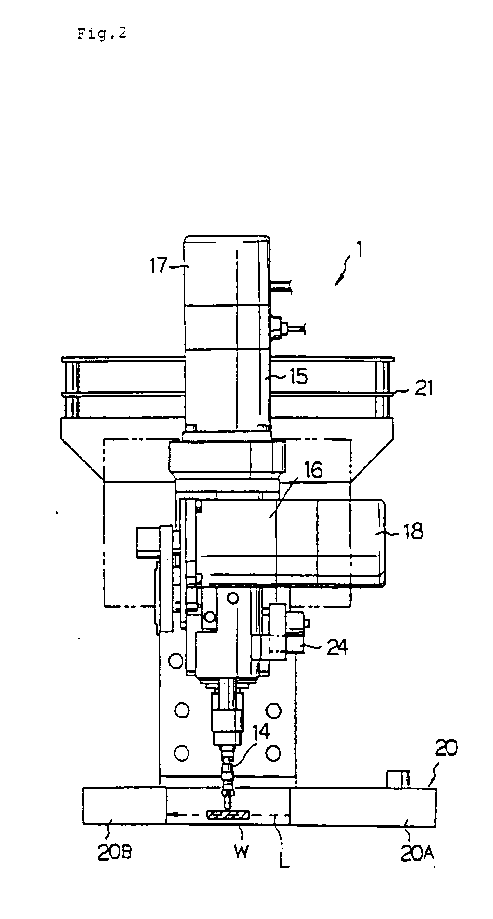

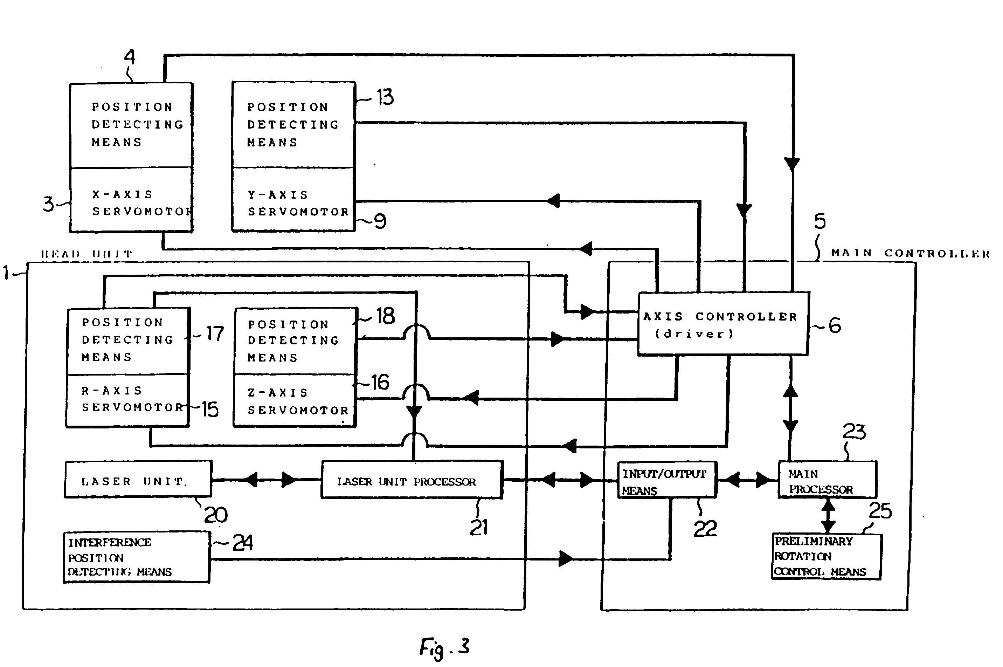

First is described the basic structure of the component mounting apparatus according to this invention referring to Figures 1 through 3. Figure 1 is a perspective view of a component mounting apparatus according to this invention, Figure 2 is a front view of a head unit equipped on the component mounting apparatus above, and Figure 3 is a block diagram showing the structure of the component mounting apparatus above.

The component mounting apparatus according to this invention is provided with a head unit 1 which is movable in the X-Y-plane as shown in Fig. 1.

The head unit 1 is movably engaged with a ball screw 2 rotatably disposed along the X-axis, and is moved in the X-axis direction on the ball screw 2 by the rotation of the ball screw 2 caused by an X-axis servomotor 3. The servomotor 3 is provided with a position detecting means 4 therefore, and the servomotor 3 and the detecting means 4 are electrically connected with the axis controller (driver) 6 of the main controller 5 as shown in Fig. 3.

The ball screw 2 and the X-axis servomotor 3 are supported for movement in the Y-axis direction along a pair of rails 7 installed in parallel to each other, and these are movably engaged with a ball screw 8 rotatably disposed along the Y-axis direction. When the Y-axis servomotor 9 is actuated, its rotation is transmitted to the ball screw 8 through a pulley 10, belt 11 and pulley 12. Then the ball screw 2, X-axis servomotor 3 and head unit 1 are moved in the Y-axis direction along the ball screw 8. The Y-axis servomotor 9 is provided with a position detecting means 13 therefore, and the servomotor 9 and the detecting means 13 are electrically connected with the axis controller (driver) 6 of the main controller 5 as shown in Fig. 3.

Therefore, when the ball screws 2 and 8 are rotated by the X-axis servomotor 3 and by the Y-axis servomotor 9, respectively, the head unit 1 can move to an arbitrary position in the X-Y-plane as described before.

Here is described the structure of the head unit 1 referring to Fig. 2.

The reference numeral 14 denotes an attracting nozzle for attracting the component K through vacuum, and the attracting nozzle 14 can be both rotated about its center axis (R-axis) by the R-axis servomotor 15 and moved up or down in the Z-axis direction by the Z-axis servomotor 16. The R-axis servomotor 15 and the Z-axis servomotor 16 are provided with a position detecting means 17 and 18, respectively, and these sets of servomotors and position detectors (15 and 17) and (16 and 18) are electrically connected with the axis controller (driver) 6 of the main controller 5 as shown in Fig. 3.

On the lower end of the head unit 1 is installed a laser unit 20, an optical detecting means, having a laser generator 20A and a detector (CCD) 20B disposed opposite to each other on both sides of the attracting nozzle 14. The laser unit 20 is electrically connected with the laser unit processor 21, which is in turn connected with the main processor 23 through the input-output means 22 of the main controller 5. In addition, the position detecting means 17 is connected with the laser unit 20, and, as shown in Figure 3, to the main processor 23 is connected a preliminary rotation control means 25.

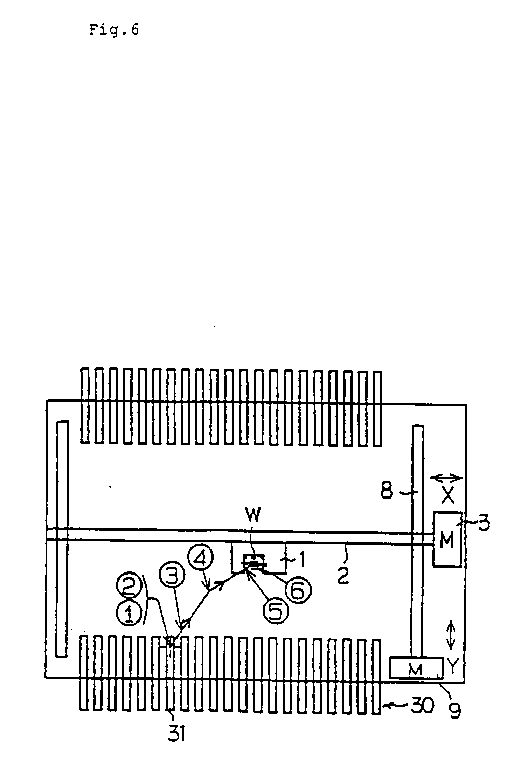

Further, the head unit 1 is provided with an interference position detecting means 24 for detecting the position of interference of a component supplying unit 30 to be described later (see Fig. 6) and the attracting nozzle 14, and the interference position detecting means 24 is connected with the input-output means 22 of the main controller 5.

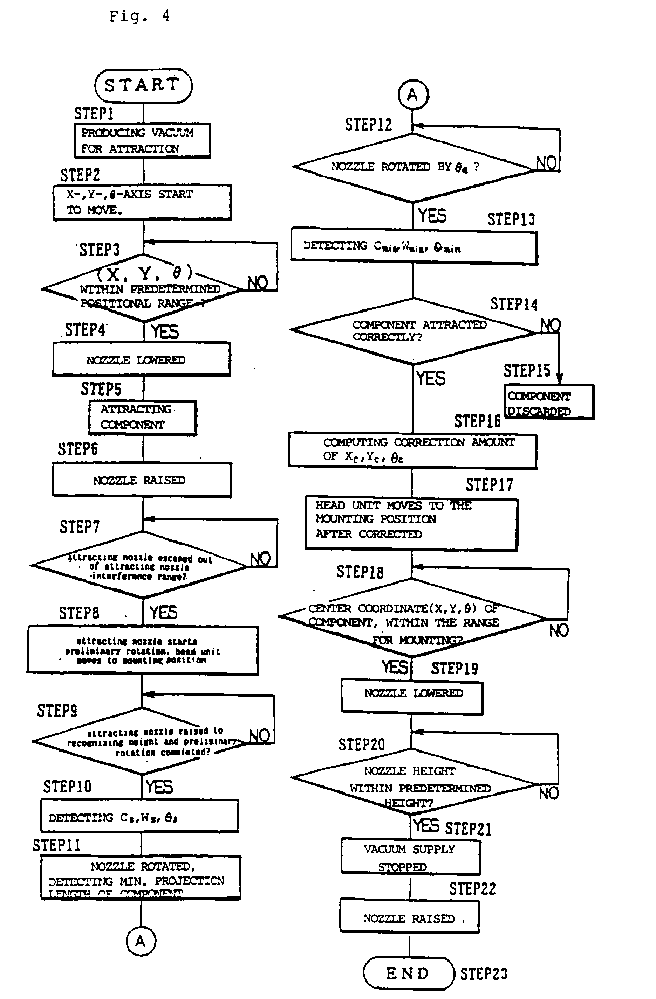

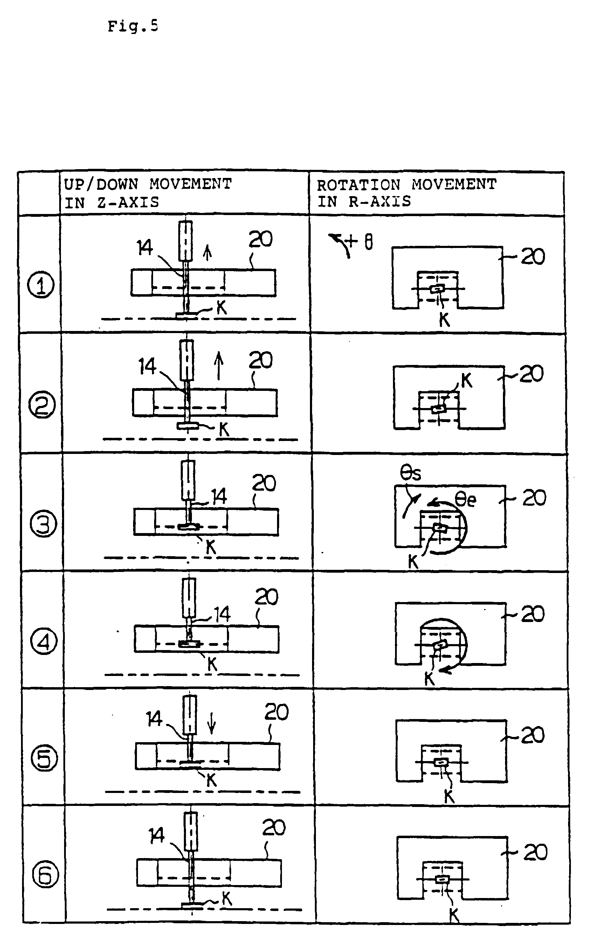

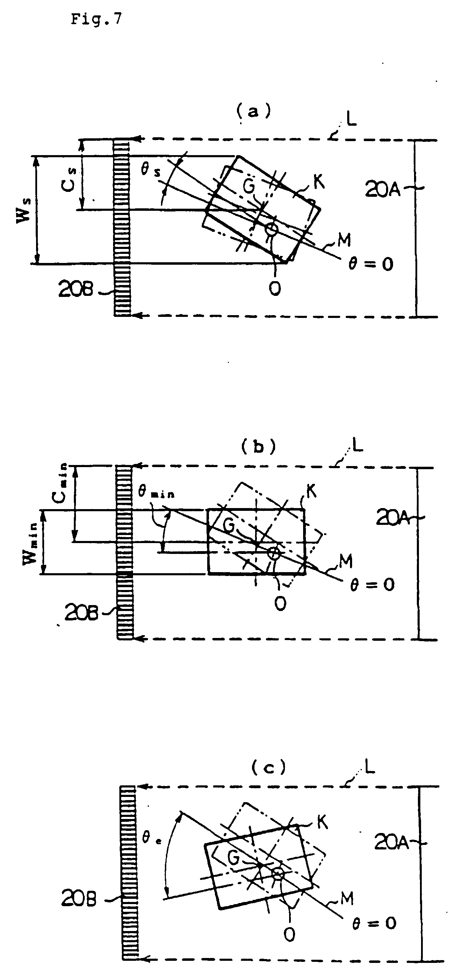

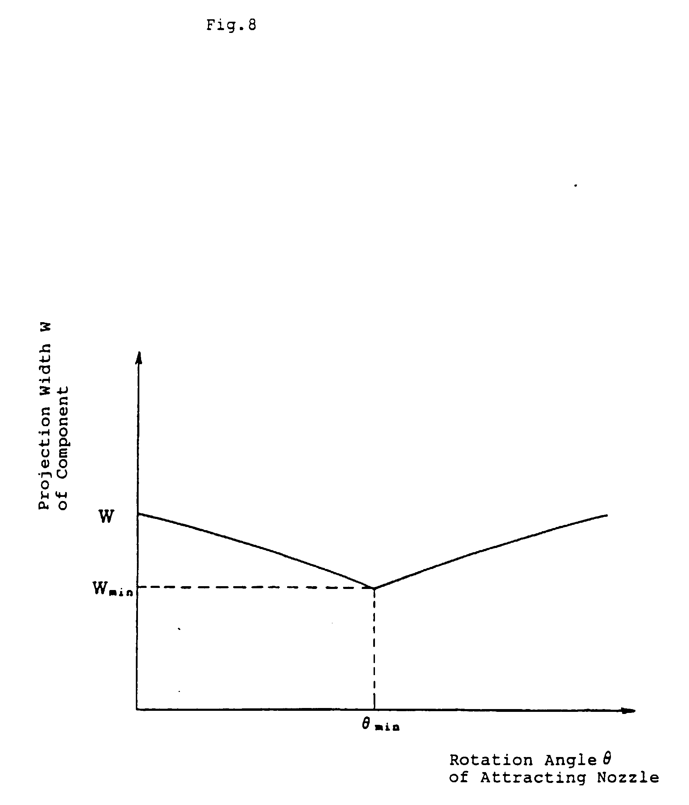

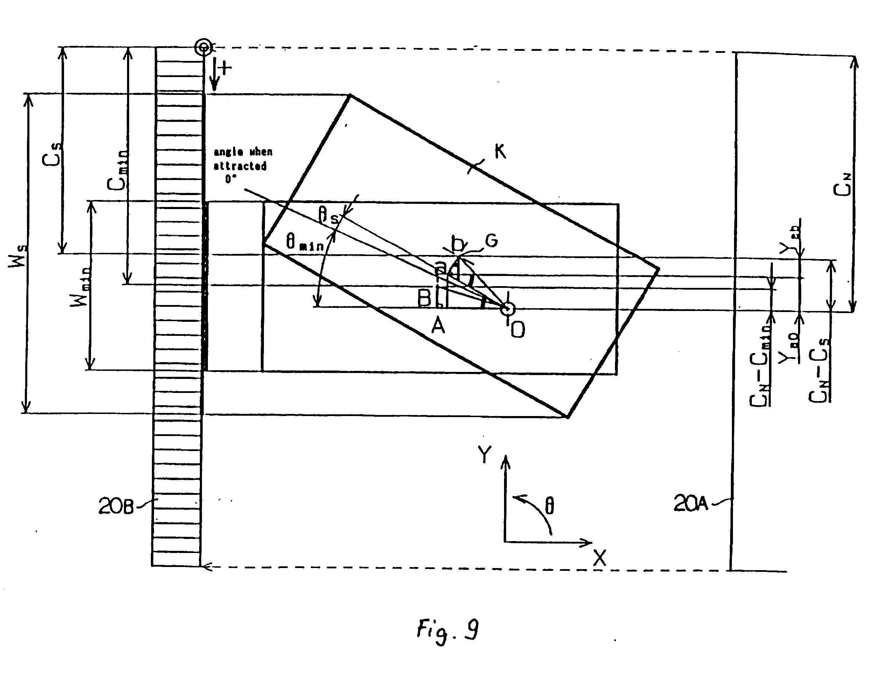

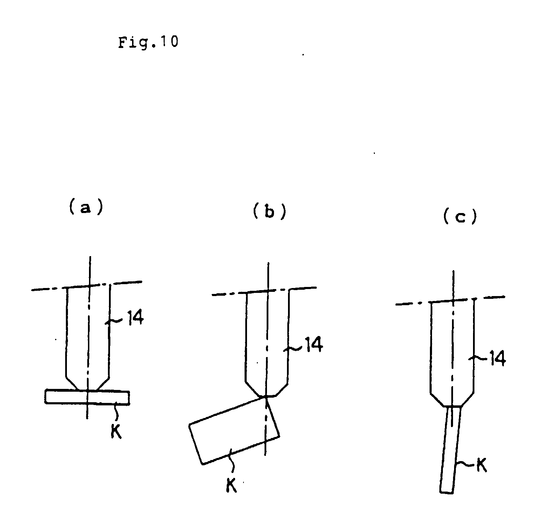

Next are described the method and procedure for mounting a component K using this component mounting apparatus referring to Figs. 4 through 9. Fig. 4 is a flow chart showing the component mounting procedure. Fig. 5 is an explanatory table showing the Z-axis (up-down) movement and the R-axis (rotating) movement at each step. Fig. 6 corresponding to Fig. 5 is a plan view showing the movement of the head unit (attracting nozzle). Figs. 7(a) through 7(c) are explanatory illustrations showing the method for detecting the minimum width of projection. Fig. 8 is a diagram showing the change in projection width of the component versus its rotation angle. Fig. 9 is an explanatory illustration for deriving the calculating equation of the X-direction mounting position correction amount $X_c$. Figs. 10(a) through 10 (c) are illustrations showing the various attracted states of the component

When attracting the component K, first is produced an attractig vacuum in the attracting nozzle 14 (step 1 in Fig. 4), then the X-axis, Y-axis and R-axis servomotors 3, 9 and 15 are actuated so that the head unit 1 may be moved in the X-Y-plane to the position above the specified feeder 31 of the component supplying unit 30 (component attracting position) and the attracting nozzle may be rotated (step 2 in Fig. 4.). Here, if the coordinates of the center of the attracting nozzle 14 comes in the allowable range of the predetermined position (component attracting position) (step 3 in Fig. 4), the Z-axis servomotor 16 is actuated to lower the attracting nozzle 14 in the Z-axis direction (step 4 in Fig. 4), and the component K contained in the feeder 31 is attracted by the attracting nozzle 14 (step 5 in Fig. 4, 1 in Figs. 5 and 6). Points 1 - 6 shown in Fig. 6 show the positions of the center of the attracting nozzle 14 in the corresponding states 1 - 6 in Fig. 5.

When the component K is attracted by the attracting nozzle 14 as described above, the Z-axis servomotor 16 is again actuated and the attracting nozzle 14 is raised along the Z-axis (step 6 in Fig. 4), and then, when it is confirmed, by the interference position detecting means 24, that the attracting nozzle 14 has escaped from the range of interference with the feeder 31 (step 7 in Fig. 4), while the R-axis servomotor 15 is actuated and the attracting nozzle 14 is rotated clockwise by an angle $\theta_s$ (this is called "preliminary rotation"), the X-axis and Y-axis servomotors 3 and 9 are actuated and the head unit 1 is moved in the X-Y-plane toward the component mounting position (step 8 in Fig. 4, 2 in Figs. 5 and 6). The distances of movements of the head unit 1 (attracting nozzle 14) in the X-axis and Y-axis directions and the angle of rotation $\theta$ of the attracting nozzle 14 about the R-axis are detected by the position detecting means 4, 13 and 17, respectively, and are fed back to the axis controller 6 of the main controller 5, and the axis controller 6 controls the actuation of the respective servomotors 3, 9 and 15 on the basis of the data fed back.

Hereinafter, the above-mentioned preliminary rotation of the component is explained referring to Figure 7a.

When the component K is attracted as shown in chain lines Fig. 7(a), the attracted point of the component (corresponding to the center point of the attracting nozzle 14 is taken as O, and the line M passing through the attracted point O in parallel to the longer side of the component K is taken as the rotation starting line ($\theta = O$) of the attracting nozzle 14.

The R-axis servomotor 15 is actuated by and under control of the preliminary rotation control means 25, with the component K attracted to the attracting nozzle 14, and said R-axis servomotor 15 preliminary rotates the attracting nozzle 14 clockwise by an angle $\theta_s$, thus the component K is rotated in the same sense by the same angle $\theta_s$ about the attracted point O from the chain line position to the solid line position shown in Fig. 7(a). This preliminary rotation is an action practiced to securely produce the state of the component K in which its projection width W on the Y-axis becomes minimal (state shown in Fig. 7(b)). Then, when it is confirmed that the attracting nozzle 14 reached the recognizing height at which the laser unit 20 can recognize it and the preliminary rotation is completed (step 9 in Fig. 4) the laser unit 20 starts detecting the component K (step 10 in Fig. 4, 3 in Figs. 5 and 6).

Hereinafter the method for detecting the component K by the laser unit 20 is described referring to Figures 7a, 7c and 7b.

Here, if a laser beam (L) is emitted in parallel to the X-axis from the laser generator 20A of the laser unit 20 while the component K is in a state shown in solid lines in Figure 7a due to the preliminary rotation explained above, since the light intensity of the laser beam (L) is lower in the portion of the detector 20B corresponding to the projection width $W_s$ of the component K on the detector 20B (Y-axis) as the laser beam (L) is intercepted by the component K, the projection width $W_s$ of the component K on the Y-axis is detected by the detector 20B. At the same time, the center position $C_s$ of the projection width $W_s$ of the component K and the rotation angle $\theta_s$ of the attracting nozzle 14 are also detected, and these values $W_s$, $C_s$ and $\theta_s$ are fed to the main processor 23 of the main controller 5 through the laser unit processor 21 and the input-output means 22 of the main controller 5.

When the detections above are completed, the R-axis servomotor 15 is actuated, the attracting nozzle 14 is rotated counterclockwise by a specified angle $\theta_e$ (e.g., 45°), the component K is also rotated about the attracted point O from its chain line position in Fig. 7(a) to its solid line position in Fig. 7(c) as shown in Fig 7(c), and, during this rotation, the projection width W of the component K on the Y-axis is detected by the laser unit 20 (step 11 and 12 in Fig. 4).

If the projection width W of the component K on the Y-axis is detected by the laser unit 20 while rotating the component K as described above, the projection width W first decreases gradually with the increase in the rotation angle $\theta$ as shown in Fig. 8, and reaches its minimum in the state of the component K shown in Fig. 7(b) (the state in which the longer side of the component K becomes parallel to the X-axis).

In the state described above, the minimum projection width $W_{min}$ of the component K, the center position $C_{min}$ of the projection width $W_{min}$ and the rotation angle $\theta_{min}$ of the attracting nozzle 14 are detected (step 13 in Fig. 4), and these values $W_{min}$, $C_{min}$ and $\theta_{min}$ are fed to the main processor 23 of the main controller 5 through the laser unit processor 21 and the input-output means 22 of the main controller 5.

Thereafter, the main processor 23 of the main controller 5 judges whether the component K is normally attracted as shown in Fig. 10(a), or is attracted in an abnormal (rather upright) state as shown in Fig. 10(b) or Fig 10(c) using the input data $\theta_s$, $\theta_e$, $W_{min}$ and $\theta_{min}$ (step 14 in Fig. 4), and, if the component K is not attracted normally, the component K is discarded (step 15 in Fig. 4).

Whether the component K is attracted normally or abnormally (irregularly) is decided practically by whether following equations are fulfilled or not. The component K is considered to be attracted abnormally if any one of the following equations holds:

$$W_{min} < (\text{component width} \times \text{safety factor})$$

$$W_{min} > (\text{component width} \times \text{safety factor})$$

$$\theta_{min} = \theta_s$$

$$\theta_{min} = \theta_e$$

When it is confirmed that the component K is normally attracted, the main processor 23 of the main controller 5 calculates the component mounting position correction amounts $X_c$, $Y_c$ and $\theta_c$ in the X, Y and $\theta$ directions (step 16 in Fig. 4).

Among the correction amounts $X_c$, $Y_c$ and $\theta_c$ above, correction amounts $Y_c$ and $\theta_c$ in the Y and $\theta$ directions are calculated, using the following equations:

$$Y_c = C_{min} - C_N \tag{1}$$

$$\theta_c = \theta_{min} \tag{2}$$

In the equation (1), $C_N$ is the center position (attracting point) of the attracting nozzle 14 as shown in Fig. 9, and, since this is a known value, the correction amounts $Y_c$ and $\theta_c$ are values obtainable substantially by actual measurement.

The X-direction correction amount $X_c$ is therefore obtained by calculations using data $C_s$, $\theta_s$, $C_{min}$ and $\theta_{min}$ obtained by detections. The equation for these calculations, are derived as follows referring to Fig. 9.

In Fig. 9, $\Delta$ AOB $\equiv$ $\Delta$ aOb, and, because

$$a\,b = A\,B = C_N - C_{min} \tag{3}$$

the projection length $Y_{ab}$ of the side a b on the Y-axis is obtained from the following equation:

$$Y_{ab} = (C_N - C_{min}) \cos (\theta_{min} + \theta_s) \tag{4}$$

Similarly, the projection length $Y_{ao}$ of the side a o on the Y-axis is obtained by the following equation:

$$Y_{ao} = a\,o \sin (\theta_{min} + \theta_s)$$

$$= (C_N - C_s) - Y_{ab}$$

$$= (C_N - C_s) - (C_N - C_{min}) \cos (\theta_{min} + \theta_s) \tag{5}$$

Therefore, the correction amount $X_c$ in the X-axis direction can be calculated from the equation (5) by the following equation:

$$X_c = A\,O = a\,O$$

$$= \frac{(C_N - C_s) - (C_N - C_{min})\,\text{COS}\,(\theta_{min} + \theta_s)}{\sin(\theta_{min} + \theta_s)} \tag{6}$$

After the component mounting position correction amounts $X_c$, $Y_c$ and $\theta_c$ in the X-direction, Y-direction and $\theta$-direction, respectively, are calculated as described above, the X-axis, Y-axis and $\theta$-axis servomotors 3, 9 and 15, respectively, are actuated, and the head unit 1 is moved according to the correction amounts $X_c$, $Y_c$ and $\theta_c$ (step 17 in Fig. 4, 4 in Figs 5. and 6). Then, when it is confirmed that the coordinates (X, Y and $\theta$) of the center point G of the component K comes in the range of the predetermined mounting position (step 18 in Fig. 4), the Z-axis servomotor 16 is actuated and the mounting nozzle 14 is lowered together with the component K (step 19 in Fig. 4, 5 in Figs. 5 and 6), then, when it is confirmed that its height has come in the predetermined range (step 20 in Fig 4), the attracting vacuum which has been applied to the attracting nozzle 14 is cut off (step 21 in Fig. 4), and the component K is mounted accurately at the specified position (6 in Figs. 5 and 6).

After the component K is mounted, the Z-axis servomotor 16 is actuated and the attracting nozzle 14 is raised (step 22 in Fig. 4), thus a series of mounting operation is performed (step 23 in Fig. 4).

In this embodiment, since the preliminary rotation is performed simultaneously while the attracting nozzle 14 is being raised, the time for the preliminary rotation is induded in the time for raising the attracting nozzle 14. Therefore, waste time is minimized and the component K is mounted with high efficiency.

Yet, although the Y-axis direction component mounting position correction amount $Y_c$ of the component K is obtained through detection of projection width W of the component K on the Y-axis, and the X-axis direction component mounting position correction amount $X_c$ is obtained by calculation in the embodiment above, it is of course possible that on the contrary, the X-axis direction component mounting position correction amount $X_c$ of the component K is obtained through detection of projection width of the component K on the X-axis, and the Y-axis direction component mounting position correction amount $Y_c$ is obtained by calculation.

In the following further component mounting apparatuses are explained in as far as they differ from the afore-described first embodiment.

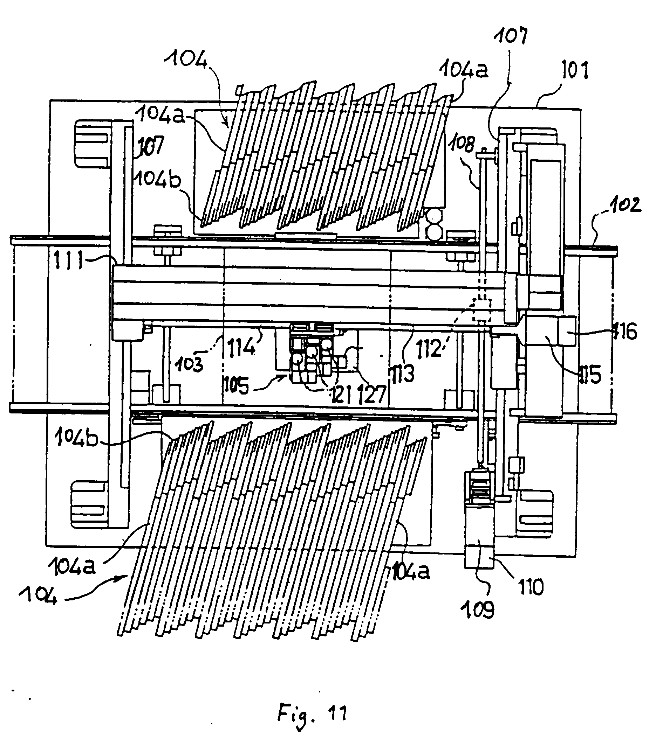

Figures 11 and 12 show an overall structure of a component mounting apparatus according to a second embodiment of the present invention. In these drawings on a base 101 is disposed a conveyor 102.

On the sides of the conveyor 102 are disposed component feeding sections 104 composed of a plurality of rows of component feeding members to be described in detail later. A head unit 105 adapted to move both in the X-axis direction (direction of the conveyor 102) and in the Y-axis direction (direction perpendicular to the X-axis direction on a horizontal plane) is installed above the base 101.

That is, while a pair of fixed rails 107 extended in the Y-axis direction across the conveyor 102 are disposed on the base 101 in parallel with each other keeping a specified distance therebetween, a ball screw 108 to be rotated by a Y-axis servomotor 109 is disposed near one fixed rail 107 as the feed mechanism in the Y-axis direction. A support member 111 for supporting the head unit 105 is movably supported on both fixed rails 107 and the nut portion 112 of the support member 111 at one end thereof is in screw-engagement with the ball screw 108 so that the support member 111 may be moved in the Y-axis direction by the rotation of the ball screw 108. The Y-axis servomotor 109 is provided with Y-axis position detecting means 101 constituted of an encoder.

The support member 111 is, while being provided with guide rails 113 extended in the X-axis direction, equipped with a ball screw 114 disposed near the guide rails 113 and an X-axis servomotor 115 for rotating the ball screw 114 as an X-axis direction feed mechanism. The head unit 105 is movably supported on the guide rails 113 and the nut portion 117 provided on the head unit 105 is in screw-engagement with the ball screw 114 so that the head unit 105 may be moved in the X-axis direction by the rotation of the ball screw 114. The X-axis servomotor 115 is provided with X-axis position detecting means 116.

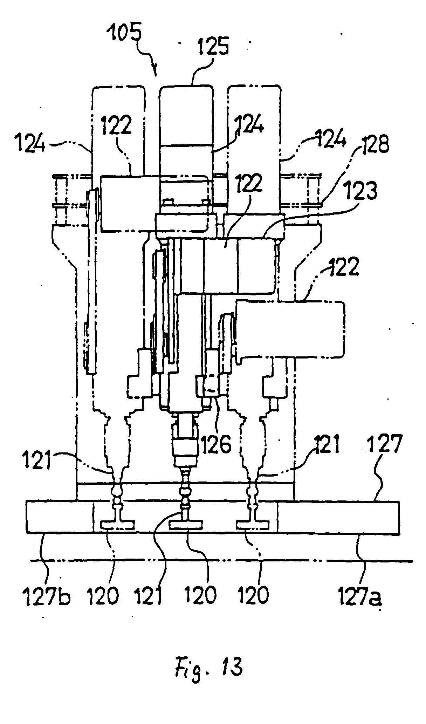

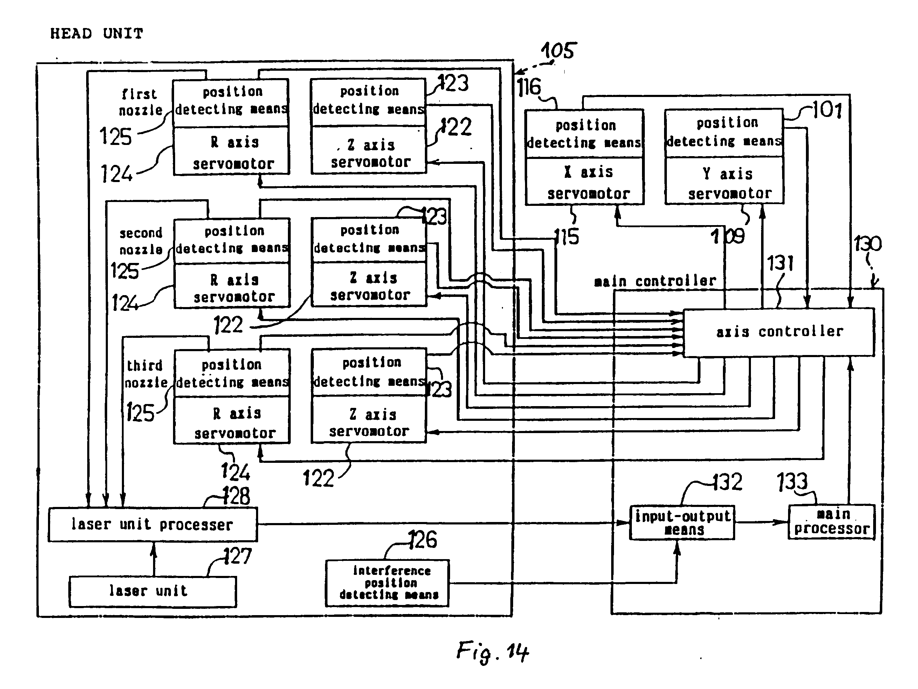

The head unit 105 is provided with a plurality of (three in this embodiment) attracting nozzles 121 for attracting chip components 120. As shown in detail in Figs. 13 and 14, each attracting nozzle 121 is provided with a Z-axis servomotor 122 and an R-axis servomotor 124 so as to be moved in the Z-axis (vertical) direction and rotated about the R-axis (nozzle center axis). The servomotors 122 and 124 are provided with position detecting means 123 and 125, respectively. Further, interference position detecting means 126 for detecting the interference position of the attracting nozzle 121 with the component feeding section 104 is installed on the head unit 105.

On the lower end portion of the head unit 105 is installed a laser unit 127 constituting the optical detecting means. The optical detecting means 127 is composed of a laser beam generating portion (parallel ray emitting portion) 127a and a detector (ray receiving portion ) constituted of a CCD, and irradiates the chip component 120 in the state attracted to the attracting nozzle 121 with laser beams, parallel rays and detects the projection width thereof.

As shown in Fig. 14 the servomotors 109, 115, 122 and 124 and position detecting means 100, 116, 123 and 125 are electrically connected to the axis controller (driver) 131 of the main controller 130. The laser unit 127 is electrically connected to the laser unit processor 128. This laser unit processor 128 is connected to the main processor through the input-output means of the main controller 130. Calculating means for obtaining the component mounting position correction amount is constituted of this main processor 133. Further, an interference position detecting means is connected to the input-output means 132.

As shown in Fig 11, the component feeding section 104 is provided with a plurality of rows of feeder tapes (component feeding members ) 104a for making it possible to feed a plurality of kinds of chip components. Each feeder tape 104a contains and holds chip components such as ICs, transistors, condensers or the like, respectively, at regular intervals, and is wound around a reel. The component feeding section 104 has a ratchet type feeder mechanism incorporated at the send-out end 104b of the feeder tape 104a and the feeder tape 104a is intermittently sent out as chip components 120 are successively picked up from the send-out end 104b by the head unit 105 so that the pick-up operation may be repeated.

As a characteristic structure of this embodiment the component feeding section 104 and the laser unit 127 are so disposed that the direction of the component disposition in the component feeding section 104 and the laser beam irradiating direction of the laser unit 127 may be inclinded relative to each other by a specified angle, and indined in the direction of the component disposition in the component feeding section 4 in this embodiment.

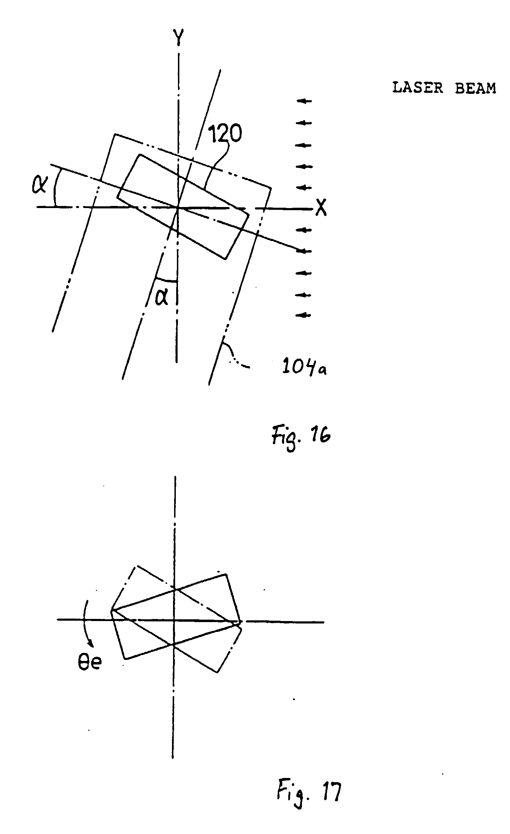

Describing the relation between the component disposing direction and the laser beam irradiating direction referring to Figs. 11 and 16, the laser unit 127 is so disposed that the laser beam may be emitted in the X-axis direction. On the other hand, the component feeding section 104 is so disposed that the direction of the feeder tape 104a in the plan view may be inclined relative to the Y-axis by a specified angle α and, therefore, the direction perpendicular to the feeder tape direction may be inclined relative to the laser beam direction by the specified angle α, while the chip components 120 are so contained in the feeder tape 104a that the longer side thereof may be generally perpendicular to the feeder tape direction. The angle α above is so specified as to correspond to the error range of the rotation angle of the component 120.

As shown in Fig. 11, the attracting nozzles 121 of the head unit 105 are arranged in a direction indined relative to the X and Y-axes to avoid lapping in the laser beam irradiating direction. The send-out ends 104b of feeder tapes 103a in the component feeding section 104 are arranged in a direction corresponding to the arranging direction of the attracting nozzles 121.

Next is described the chip component mounting operation on the apparatus according to this embodiment.

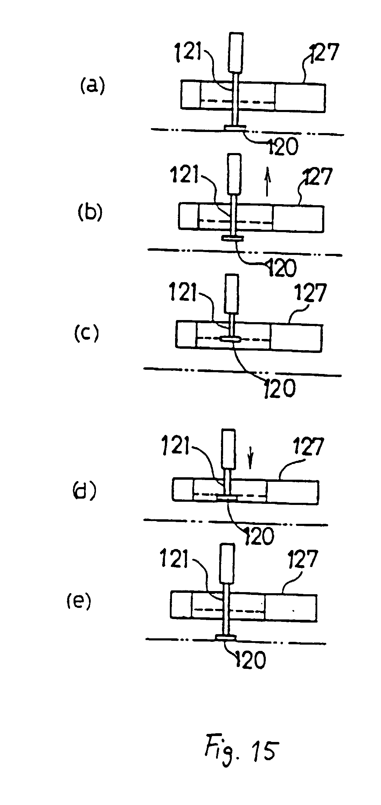

According to the predetermined program, first, while the attracting nozzle 121 is fed with vacuum by a vacuum producing means (not shown), the head unit 105 is moved in both X-axis and Y-axis directions to the position corresponding to the component feeding section 104, then, when it reaches the attracting position, the attracting nozzle is lowered (Fig 15(a)) and attracts a chip component held at the send-out end 104b of the feeder tape 104a. Then the attracting nozzle 121 is raised, and, when raised to a position where the attracting nozzle 121 escapes out of its interference range with the component feeding section 104, (Fig. 15(b)), the movement of the head unit 105 to the printed substrate 103 is started. Then, when the chip component 120 is raised to a position corresponding to the height at which component 120 can be recognized by the laser unit 127 (Fig. 15(c)), the process for correcting the component mounting position (to be described later) is practiced in parallel with the movement of the head unit 105. Then, the attracting nozzle 121 is lowered when the head unit 105 reaches the corrected component mounting position. When the component 120 is lowered to the predetermined height close to the printed substrate 103, the vacuum fed to the attracting nozzle is cut off, and the component 120 is mounted on the printed substrate 103. Thereafter, the attracting nozzle 121 is raised, and a series of attracting and mounting operation is completed.

Although only one attracting nozzle 121 is shown in Fig. 15 to simplify description, when a plurality of attracting nozzles 121 are provided, all attracting nozzles attract and mount components 120 respectively. In this case, if the arrangement of the attracting nozzles 121 and the arrangement of the send-out ends 104b of the feeder tapes 104a correspond to each other as shown in Fig. 11, it becomes possible for a plurality of attracting nozzles to simultaneously attract the same number of chip components 120.

The process for correcting the component mounting position to be practised in the attracting and mounting operation above is described referring to Figs. 16 and 17.

In the state of the chip component 120 just attracted to the attracting nozzle 121 and raised as it is, the direction of the longer side of the chip component 120 is within a definite rotation angle error range around the direction perpendicular to the feeder tape direction, but, since the chip component arranging direction (direction perpendicular to the direction of the feeder tape 104a) is indined by a specified angle a relative to the laser beam direction (X-axis direction), the chip component 120 is always in a state indined in the negative direction (dockwise as shown) relative to the laser beam direction even if the rotation angle error above exists (Fig. 16). Therefore, correcting process will be achieved as described below even if preliminary rotation in the negative direction is not practiced.

Starting from the intitial state shown in Fig. 16, the attracting nozzle is rotated by a definite angle θ (e.g., 45°) in the positive direction (counterclockwise) (Fig. 17). During this rotation, the laser beam emitted by the laser emitting portion 127a of the laser unit 127 is received by the detector 127b and the projection width of the chip component 120 is detected. In this case, the change of the projection width in relation to the rotating angle $\theta$ is as shown in Fig. 8 and the projection width becomes minimum when the longer side of the chip component 120 comes in a state corresponding to the laser beam direction during the rotation by a definite angle.

The projection width $W_s$ and its center position $C_s$ in the initial state above, the projection width $W_{min}$ and its center position $C_{min}$ in the minimum projection width state, and the rotating angle $\theta_m$ from the initial state to the minimum projection width state are read into the main processor 133 through the laser unit processor 128 and the input-output means 132, and, on the basis of these values, the component mounting position correction amounts $X_c$, $Y_c$ and $\theta_c$ are calculated by the main processor 133.

That is, if the chip component 120 is to be mounted in a state with its longer side extended in the X-axis direction, the correction amounts $Y_c$ and $\theta_c$ in the Y and $\theta$ direction among the component mounting position correction amounts $X_c$, $Y_c$ and $\theta_c$ are given by the following equations:

$$Y_c = C_m - C_N,$$

$$\theta_c = \theta_m,$$

where $C_N$ is the center position of the attracting nozzle (attracting point), a known value.

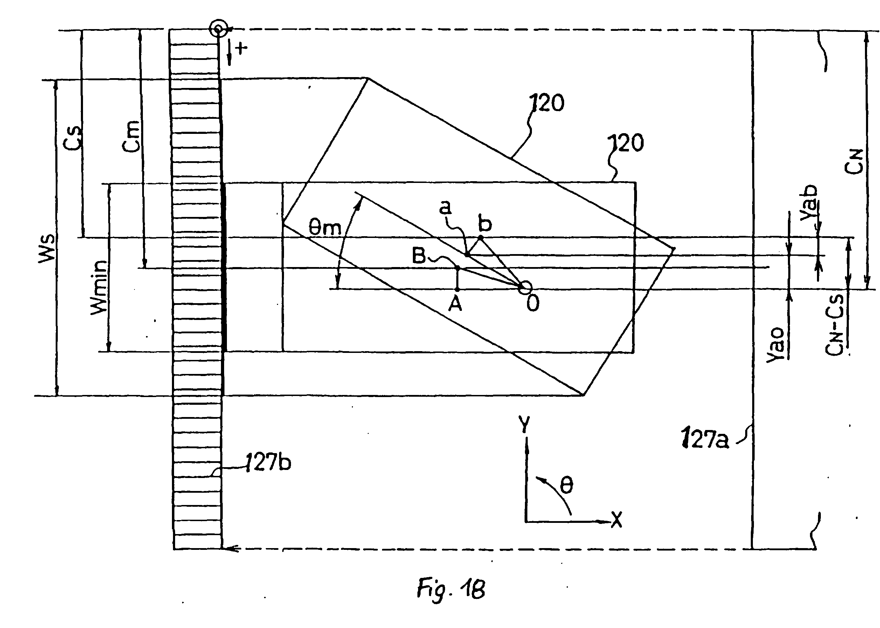

In this embodiment, the X direction correction amount $X_c$ is obtained by calculation using data obtained by detection, and the calculation above is described hereafter referring to Fig. 18. In Fig. 18 O is the center point of the attracting nozzle, b and B are chip component center points in the initial state and in the minimum projection width state, respectively, and $\triangle aOb \equiv \triangle AOB$.

When taken as follows:

$L_{AB}$ : length of the segment AB
$L_{ab}$ : length of the segment ab
$L_{AO}$ : length of the segment AO
$L_{ao}$ : length of the segment ao
$Y_{ab}$ : projection length of the segment ab on the Y-axis
$Y_{aO}$ : projection length of the segment aO on the Y-axis

$$C_N - C_s = Y_{ao} + Y_{ab},$$

$$Y_{ao} = L_{ao} \sin \theta_m$$

and

$$Y_{ab} = L_{ab} \cos \theta_m$$

Since $L_{ao} = L_{AO} = X_c$, and $L_{ab} = L_{AB} = C_N - C_m$, $X_c$ is derived from the equations above as shown in the following equation:

$$X_c = ((C_N - C_s) - (C_N - C_m). \cos \theta_m)/\sin \theta_m.$$

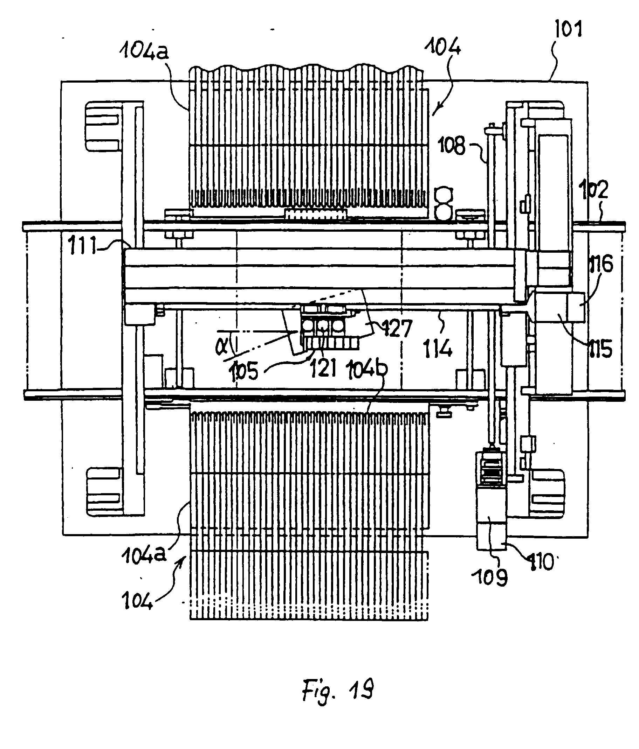

Fig. 19 shows a third embodiment of this invention. In this embodiment, the component disposing direction in the component feeding section 104 and the laser beam direction of the laser unit 127 are indined relative to each other by a specified angle, and inclined is the laser beam direction. That is, the feeder tape 104a of the component feeding section is disposed in the Y-axis direction, the send-out ends 104b of the feeder tapes 104a are aligned in the X-axis direction, and the attracting nozzles 121 of the head unit 105 is also aligned in the X-axis direction. On the contrary, the laser unit 127 is installed on the head unit 105 in a disposition wherein its laser beam is inclined relative to the X-axis by a specified angle $\alpha$.

With the third embodiment also, since a state of the chip component 120 indined in the same sense relative to the laser beam direction is always secured, the preliminary rotation for the component mounting position correction becomes unnecessary. It is also the same as in the first embodiment that a plurality of components 120 can be simultaneously attracted by a plurality of attracting nozzles 121 in the second embodiment.

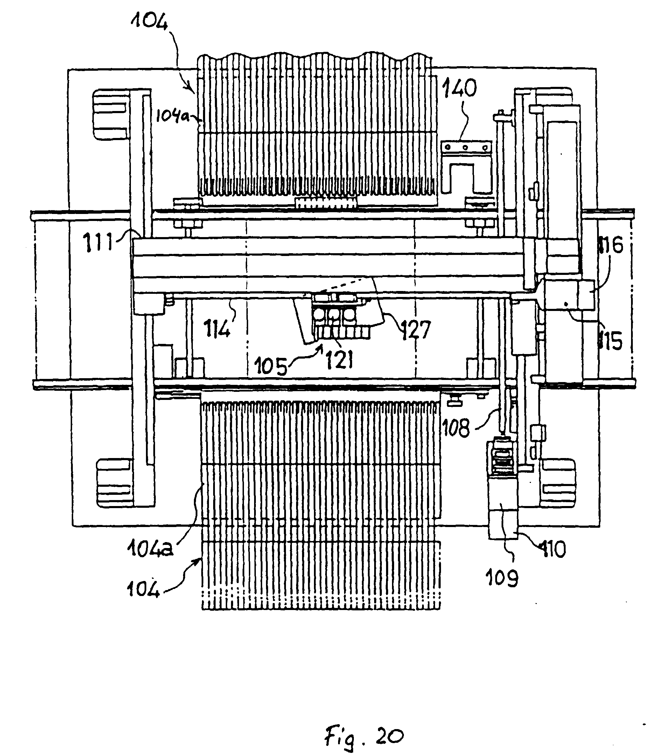

Fig. 20 shows a fourth embodiment of this invention. In this embodiment, while the laser unit 127 is installed on the head unit in the same manner as in the third (or second) embodiment, a laser unit 140 of a larger type is fixed on the base 101.

When using this embodiment, while the laser unit 127 attached to the head unit 105 is used when the component is of a smaller type and the correction process is practiced while the head unit 105 is moving to the component mounting position, it is possible to transfer the component to the fixed laser unit140 and correct the mounting position on the basis of the detection results there when the component is of a larger type and detection by the laser unit 127 is attached to the head unit 105 is difficult.

Although the head unit is provided with a plurality of attracting nozzles on the embodiments above, the number of the attracting nozzle is not limited but may be only one. Further, the practical structure of various portions of the apparatus may be modified without deviating from the purpose of this invention.

Since the component mounting apparatus according to the afore-described embodiments is, while being provided with optical detecting means for irradiating the chip component attracted to the attracting nozzle with parallel rays and detecting its projection width and means for obtaining the component mounting position correction amount while rotating the attracting nozzle in the specified direction on the basis of the detection result of the optical detecting means, so constructed that the direction of the component disposition in the component feeding section and the light ray irradiating direction of the optical detecting means may be inclined relative to each other by a specified angle, the state of the chip component inclined in a specified direction relative to the parallel rays above is always secured as attracted to the attracting nozzle, and the correction amount can be obtained. Therefore, the time required for correction can be shortened and the operation efficiency can be improved.

Further, by providing the head unit with a plurality of attracting nozzles in parallel with one another, arranging these attracting nozzles in a direction inclined relative to the light ray irradiating direction of the optical detecting means and making the arrangement of the component feeding member correspond to the arrangement of the attracting nozzles, a plurality of components can be simultaneously attracted and mounted in addition to the effects above, and the operation efficiency can be further improved.

## Claims

1. Method for mounting a component (K) at a specific position, preferably on a substrate such as a printed circuit board, by means of attracting the component by an attracting nozzle (14) from a component supply unit (30), transferring the component and mounting same at the desired position, **characterized in that,** the component (K), after being attracted through the attracting nozzle (14), is preliminary rotated by a certain angle ($\theta_s$) about a vertical axis (R) of the attracting nozzle (14) while simultaneously being raised by said attracting nozzle (14) in the direction of a vertical Z-axis to set the component (K) in a predetermined starting position for further detection of a minimum projection width ($W_{min}$) of the component (K) after same has been moved into a detection area of an optical detecting means (20).

2. Method as claimed in claim 1, **characterized in that ,** the component (K) is rotated in the detection area of the optical detecting means (20) in a sense opposite to the preparatory preliminary rotation, wherein the projection width (W) of the component (K) is obtained during rotation of the component (K) in the detection area of the optical detecting means (20), and in that correcting amounts ($X_{c'}, Y_{c'}, \theta_c$) for the mounting position of the component (K) are calculated.

3. Apparatus for mounting a component (K) at a specific position, preferably on a substrate such as a printed circuit board, comprising a movable mounting head unit (1) supporting an attracting nozzle (14) for attracting by vacuum a component (K) to be mounted from a component feeding section (31) of a component supply unit (30), a component position detecting means (20) and a main control unit (5) for controlling the operation of the apparatus for performing the method according to claim 1, wherein said attracting nozzle (14) is supported rotatably about its vertical center axis (R) and the detecting means is an optical detecting means (20) to provide a projection of the component (K) and to detect the projection width (W) of the component (K) as well as to obtain mounting position correcting amounts ($Y_{c'}, \theta_c$), **characterized in that**, a preliminary rotation control means (25) is connected to a main processor (23) of the main control unit (5) and in that said main control unit (5) is adapted to preliminary rotate said component (K) after being attracted through said attracting nozzle (14) by a certain angle ($\theta_s$) about the vertical axis (R) of the attracting nozzle (14) while the component (K) is simultaneously raised by said attracting nozzle (14) to said detection means.

4. Apparatus as claimed in claim 3, **characterized in that**, the main processor (23) is provided for calculating at least one mounting position correcting amount ($X_c$) of the component's mounting position in response to the other correcting amounts ($Y_{c'}, \theta_c$) measured.

5. Apparatus as claimed in claims 3 or 4, **characterized in that**, the mounting head unit (1) is supported to be movable in a horizontal X-Y-plane.

6. Apparatus as claimed in at least one of the preceding claims 3 to 5, **characterized in that**, the mounting head unit (1) is movable in the X-axis direction through a servomotor (3) having a position detecting means (4) associated thereto, and that the head unit (1) is movable in the Y-axis direction through its servomotor (9) having a position detecting means (13) associated thereto, said servomotors (3,9) and associated position detecting means (4,13) are electrically connected to an axis controlling and driving means (6) of the main control unit (5).

7. Apparatus as claimed in at least one of the preceding claims 3 to 6, **characterized in that** the attracting nozzle (14) is rotatably supported at the mounting head unit (1) through an R-axis servomotor (15) and is slideably supported to be vertically slideable along the Z-axis through a Z-axis servomotor (16), with respective position detecting means (17,18) being associated to the servomotors (15,16), said servomotors (15,16) and said position detecting means (17,18) being electrically connected to the axis controlling and driving means (6) of the main control unit (5).

8. Apparatus as claimed in at least one of the preceding claims 3 to 7 **characterized in that** a laser beam unit (20) is installed as the optical detecting means at a lower end of the mounting head unit (1), said laser beam unit (20) comprising a laser beam generator (20A) and a detector (20B) disposed opposite to each other on both sides of the attracting nozzle (14).

9. Apparatus as claimed in at least one of the preceding claims 3 to 8, **characterized in that** the laser beam unit (20) is electrically connected to a laser unit processor (21) which is connected to a main processor (23) through an input-output means (22) of the main control unit (5).

10. Apparatus as claimed in at least one of the preceding claims 3 to 9, **characterized in that** the mounting head unit (1) comprises an interference position detecting means (24) which is adapted to detect a position of interference of the component supplying unit (30) and the attracting nozzle (14), said interference position detecting means (24) being connected to the input-output means (22) of the main control unit (5).

11. Apparatus for mounting a component (120) at a specific position, preferable on a substrate such as a printed circuit board, comprising a moveable mounting head unit (105) supporting at least one attracting nozzle (121) for attracting by vacuum at least one component (120) to be mounted from a component feeding section (104) of a component supply unit, a component position detecting means (127) and a main control unit (130) for controlling the operation of the apparatus, wherein said at least one attracting nozzle (121) is supported rotatably about its vertical center axis (R), and the detecting means is an optical detecting means (20) to provide a projection of the component (120) and to detect the projection width (W) of the component (120) as well as to obtain mounting position correcting amounts ($Y_{c'}, \theta_c$), **characterized in that**, at least one component feeding section (104) and the optical detecting means (127) are disposed such that a light ray irradiating direction of the optical detecting means (127) defines a predetermined angle ($\alpha$) of inclination to the direction of the disposition of the components (120) in the component feeding section (104).

12. Apparatus as claimed in claim 11, **characterized in that** , the mounting head unit (105) supports rotatably and slideably a plurality of attracting nozzles (121) while a plurality of component feeding sections (104) composed of a plurality of rows of component feeding members (104a) is provided, wherein a direction of arrangement of the attracting nozzles (121) and the direction of light ray irradiation extends inclined relative to each other so as to set each component (120) in a state inclined in a certain direction relative to a light beam direction, while the directions of arrangement of the attracting nozzles (121) and the send-out ends (104b) of the component feeding members (104a) correspond to each other.

13. Apparatus as claimed in claims 11 or 12, **characterized in that**, the optical detecting means (127) comprises a laser beam generating portion (127a) emitting laser beams in parallel rays in parallel to a X-axis direction, while the component feeding section (104) is disposed to align a plurality of feeder tapes (104a) included (in plan view) relative to an Y-axis by the predetermined angle ($\alpha$).

14. Apparatus as claimed in claim 13, **characterized in that**, said angle ($\alpha$) corresponds to an error range of the angle of rotation of the component (20).

15. Apparatus as claimed in at least one of the preceding claims 11 to 14, **characterized in that**, said components comprise chip components (120) disposed on the feeder tape (104a) such that a longer side of the chip component (120) extends generally perpendicularly to the feeder tape direction.

**Patentansprüche**

1. Verfahren zum Montieren eines Bauteiles (K) an einer speziellen Stelle, vorzugsweise auf einem Substrat wie z. B. einer gedruckten Leiterplatte, durch Anziehen des Bauteiles durch eine Anzugsdüse (14) von einer Bauteil-Liefereinheit (30), Fördern des Bauteiles und Montieren desselben an der gewünschten Stelle, **dadurch gekennzeichnet**, daß das Bauteil (K), nachdem es durch die Anzugsdüse (14) angezogen worden ist, um eine vertikale Achse (R) der Anzugsdüse (14) über einen bestimmten Winkel ($\theta_s$) vorläufig gedreht wird, während es gleichzeitig durch die Anzugsdüse (14) in Richtung einer vertikalen Z-Achse angehoben wird, um das Bauteil (K) in eine vorgegebene Startposition zur weiteren Erfassung einer minimalen Projektionsbreite ($W_{min}$) des Bauteiles (K) zu bringen, nachdem dieses in einen Erfassungsbereich einer optischen Erfassungseinrichtung (20) bewegt worden ist.

2. Verfahren nach Anspruch 1, **dadurch gekennzeichnet**, daß das Bauteil (K) in dem Erfassungsbereich der optischen Erfassungseinrichtungen (20) in einem Sinn entgegengesetzt zu der vorbereitenden vorläufigen Drehung gedreht wird, wobei die Projektionsbreite (W) des Bauteiles (K) während der Rotation des Bauteiles (K) im Erfassungsbereich der optischen Erfassungseinrichtung (20) erhalten wird, und daß Korrekturbeträge ($X_c$, $Y_c$, $\theta_c$) für die Montageposition des Bauteiles (K) berechnet werden.

3. Einrichtung zur Montage eines Bauteiles (K) an einer speziellen Stelle, vorzugsweise auf einem Substrat wie z.B. einer gedruckten Leiterplatte mit einer beweglichen Montagekopfeinheit (1), die eine Anzugsdüse (14) zum Anziehen eines zu montierenden Bauteiles (K) durch Vakuum von einem Bauteil-Zuführungsabschnitt (31) einer Bauteil-Liefereinheit (30) lagert, einer Bauteilpositions-Erfassungseinrichtung (20) und einer Hauptsteuereinheit (5) zum Steuern des Betriebes der Einrichtung zur Ausführung des Verfahrens nach Anspruch 1, wobei die Anzugsdüse (14) um ihre vertikale Mittelachse (R) drehbar gelagert ist und die Erfassungseinrichtung eine optische Erfassungseinrichtung (20) ist, um eine Projektion des Bauteils (K) bereitzustellen und die Projektionsbreite (W) des Bauteils (K) zu erfassen, sowie um Montagepositions-Korrekturbeträge ($Y_c$, $\theta_c$) zu erhalten, **dadurch gekennzeichnet**, daß eine Steuereinrichtung (25) für eine vorläufige Rotation mit einem Hauptprozessor (23) der Hauptsteuereinheit (5) verbunden ist, und daß die Hauptsteuereinheit (5) ausgebildet ist zum vorläufigen Drehen des Bauteils (K), nachdem dieses von der Anzugsdüse (14) angezogen wurde, über einen bestimmten Winkel ($\theta_s$) um die vertikale Mittelachse (R) der Anzugsdüse (14) während das Bauteil (K) gleichzeitig durch die Anzugsdüse (14) zu der Erfassungseinrichtung angehoben wird.

4. Einrichtung nach Anspruch 3, **dadurch gekennzeichnet**, daß der Hauptprozessor (23) vorgesehen ist, um zumindest einen Montagepositions-Korrekturbetrag ($X_c$) der Montageposition des Bauteils in Abhängigkeit von den anderen gemessenen Korrekturbeträgen ($Y_c$, $\theta_c$) zu berechnen.

5. Einrichtung nach Anspruch 3 oder 4, **dadurch gekennzeichnet**, daß die Montagekopfeinheit (1) so gelagert ist, daß sie in einer horizontalen X-Y-Ebene beweglich ist.

6. Einrichtung nach zumindest einem der vorhergehenden Ansprüche 3 - 5, **dadurch gekennzeichnet**, daß die Montagekopfeinheit (1) in Richtung der X-Achse durch einen Servomotor (3) bewegbar ist, mit dem eine Positions-Erfassungseinrichtung (4) verbunden ist, und daß die Kopfeinheit (1) in Richtung der Y-Achse durch ihren Servomotor (9) bewegbar ist, mit dem eine Positions-Erfassungseinrichtung (13) verbunden ist, wobei die Servomotoren (3, 9) und die zugehörigen Positions-Erfassungseinrichtungen (4, 13) elektrisch mit einer Achsensteuerungs- und - antriebseinrichtung (6) der Hauptsteuereinheit (5) verbunden sind.

7. Einrichtung nach zumindest einem der vorhergehenden Ansprüche 3- 6, **dadurch gekennzeichnet**, daß die Anzugsdüse (14) an der Montagekopfeinheit (1) durch einen R-Achsen-Servomotor (15) drehbar gelagert ist, und gleitbar gelagert ist, um vertikal entlang der Z-Achse durch einen Z-Achsen-Servomotor (16) verschiebbar zu sein, mit jeweiligen Postions-Erfassungseinrichtungen (17, 18), die den Servomotoren (15, 16) zugeordnet sind, wobei diese Servomotoren (15, 16) und die Positions-Erfassungseinrichtungen (17, 18) elektrisch mit einer Achsensteuerungs- und -antriebseinrichtung (6) der Hauptsteuereinheit (5) verbunden sind.

8. Einrichtung nach zumindest einem der vorhergenden Ansprüche 3-7, **dadurch gekennzeichnet**, daß eine Laserstrahleinheit (20) als die optische Erfassungseinrichtung an einem unteren Ende der Montagekopfeinheit (1) installiert ist, wobei die Laserstrahleinheit (20) einen Laserstrahlgenerator (20A) und ein Erfassungsglied (20B) aufweist, die gegenüberliegend zueinander zu beiden Seiten der Anzugsdüse (14) angeordnet sind.

9. Einrichtung nach zumindest einem der vorhergenden Ansprüche 3-8, **dadurch gekennzeichnet**, daß die Laserstrahleinheit (20) elektrisch mit einem Lasereinheit-Prozessor (21) verbunden ist, der mit einem Hauptprozessor (23) durch eine Eingabe-Ausgabe-Einrichtung (22) der Hauptsteuereinheit (5) verbunden ist.

10. Einrichtung nach zumindest einem der vorhergenden Ansprüche 3-9, **dadurch gekennzeichnet**, daß die Montagekopfeinheit (1) eine Behinderungspositions-Erfassungseinrichtung (24) aufweist, die vorgesehen ist, um eine Behinderungsposition der Bauteil-Liefereinheit (30) und der Anzugsdüse (14) zu erfassen, wobei die Behinderungspositions-Erfassungseinrichtung (24) mit der Eingabe-Ausgabe-Einrichtung (22) der Hauptsteuereinheit (5) verbunden ist.

11. Einrichtung zum Montieren eines Bauteiles (120) an einer speziellen Stelle, vorzugsweise auf einem Substrat wie z.B. einer gedruckten Leiterplatte, mit einer beweglichen Montagekopfeinheit (105) die zumindest eine Anzugsdüse (121) lagert, zum Ansaugen zumindest eines zu montierenden Bauteiles (120) von einem Bauteil-Zuführungsabschnitt (104) einer Bauteil-Liefereinheit durch Vakuum, einer Bauteilpositions-Erfassungseinrichtung (127) und einer Hauptsteuereinheit (130) zum Steuern des Betriebes der Einrichtung, wobei diese zumindest eine Anzugsdüse (121) um ihre vertikale Mittelachse (R) drehbar gelagert ist und die Erfassungseinrichtung eine optische Erfassungseinrichtung (20) ist, um eine Projektion des Bauteiles (120) zu schaffen und die Projektionsbreite (W) des Bauteiles (120) zu erfassen, ebenso um Montagepositions-Korrekturbeträge ($Y_c$, $\theta_c$) zu erhalten, **dadurch gekennzeichnet**, daß zumindest ein Bauteil-Zuführungsabschnitt (104) und die optische Erfassungseinrichtung (127) so angeordnet sind, daß eine Lichtstrahl-Abstrahlungsrichtung der optischen Erfassungseinrichtung (127) einen vorgegebenen Neigungswinkel ($\alpha$) zu der Richtung der Lage der Bauteile (120) in dem Bauteil-Zuführungsabschnitt (104) bildet.

12. Einrichtung nach Anspruch 11, **dadurch gekennzeichnet**, daß die Montagekopfeinheit (105) drehbar und gleitbar eine Mehrzahl von Anzugsdüsen (121) lagert, während eine Mehrzahl von Bauteil-Zuführungsabschnitte (104), bestehend aus einer Mehrzahl von Reihen von Bauteil-Zuführungsteilen (104a) vorgesehen ist, wobei eine Richtung der Anordnung der Anzugsdüsen (121) und die Richtung der Lichtstrahlabstrahlung sich geneigt relativ zueinander erstrecken, um so jedes Bauteil (120) in einen Zustand zu bringen, der in einer bestimmten Richtung relativ zu einer Lichtstrahlrichtung geneigt ist, während die Richtungen der Anordnung der Anzugsdüsen (121) und der Abgabeenden (104b) der Bauteil-Zuführungsteile (104a) einander entsprechen.

13. Einrichtung nach Anspruch 11 oder 12, **dadurch gekennzeichnet**, daß die optische Erfassungseinrichtung (127) einen Laserstrahl-Erzeugungsabschnitt (127a), der Laserstrahlen in parallelen Strahlen parallel zu einer X-Achsen-Richtung emittiert, aufweist, während der Bauteil-Zuführungsabschnitt (104) angeordnet ist, um eine Mehrzahl von Zuführungsbändern (104a) (in Draufsicht) geneigt relativ zu einer Y-Achse um den vorgegebenen Winkel ($\alpha$) auszurichten.

14. Einrichtung nach Anspruch 13, **dadurch gekennzeichnet**, daß dieser Winkel ($\alpha$) einem Fehlerbereich des Drehwinkels des Bauteiles (20) entspricht.

15. Einrichtung nach zumindest einem der vorhergehenden Ansprüche 11-14, **dadurch gekennzeichnet**, daß die Bauteile Chip-Bauteile (120) sind, die auf dem Zuführungsband (104a) derart angeordnet sind, daß eine längere Seite des Chip-Bauteiles (120) sich im wesentlichen rechtwinklig zu der Richtung des Zuführungsbandes erstreckt.

## Revendications

1. Procédé de montage d'un composant (K) à une position spécifique, de préférence sur un substrat tel qu'une carte de circuits imprimés, consistant à attirer le composant par une buse d'attraction (14) à partir d'une unité d'approvisionnement de composants (30), à transférer le composant et à monter celui-ci à la position désirée, caractérisé en ce que le composant (K), après avoir été attiré dans la buse d'attraction (14), est d'abord pivoté sur un certain angle ($\theta_s$) autour d'un axe vertical (R) de la buse d'attraction (14) tout en étant simultanément soulevé par ladite buse d'attraction (14) dans la direction d'un axe vertical Z pour placer le composant (K) dans une position de départ prédéterminée pour une nouvelle détection d'une largeur de projection minimale ($W_{min}$) du composant (K) après que celui-ci ait été déplacé dans une zone de détection des moyens de détection optique (20).

2.  Procédé selon la revendication 1, caractérisé en ce que le composant (K) est pivoté dans la zone de détection des moyens de détection optique (20) dans un sens contraire à celui de la rotation préparatoire préliminaire, pendant laquelle la largeur de projection (W) du composant (K) est obtenue pendant la rotation du composant (K) dans la zone de détection des moyens de détection optique (20) et en ce que des valeurs de correction ($X_c$, $Y_c$, $\theta_c$) pour la position de montage du composant (K) sont calculées.

3.  Dispositif de montage d'un composant (K) à une position spécifique, de préférence sur un substrat tel qu'une carte de circuits imprimés, comprenant une unité de tête de montage (1) mobile supportant une buse d'attraction (14) pour attirer par aspiration un composant (K) à monter à partir d'une section distributrice de composants (31) d'une unité d'approvisionnement de composants (30), des moyens de détection de position des composants (20) et une unité principale de commande (5) pour contrôler le fonctionnement du dispositif pour mettre en oeuvre le procédé selon la revendication 1, dans lequel ladite buse d'attraction (14) est supportée de façon pivotante autour de son axe central vertical (R) et les moyens de détection sont des moyens de détection optique (20) pour produire une projection du composant (K) et pour détecter la largeur de projection (W) du composant (K) ainsi que pour obtenir des valeurs de correction de la position de montage ($Y_c$, $\theta_c$), caractérisé en ce que les moyens de contrôle de rotation préliminaire (25) sont connectés à un processeur principal (23) de l'unité principale de commande (5) et en ce que ladite unité principale de commande (5) est conçue pour permettre la rotation préliminaire dudit composant (K) après avoir été attiré dans ladite buse d'attraction (14) sur un certain angle ($\theta_s$) autour de l'axe vertical (R) de la buse d'attraction (14) tandis que le composant (K) est soulevé simultanément par ladite buse d'attraction (14) vers lesdits moyens de détection.

4.  Dispositif selon la revendication 3, caractérisé en ce que le processeur principal (23) est conçu pour calculer au moins une valeur de correction de position de montage ($X_c$) de la position de montage du composant en réponse aux autres valeurs de correction mesurées ($Y_c$, $\theta_c$).

5.  Dispositif selon les revendications 3 ou 4, caractérisé en ce que l'unité de tête de montage (1) est supportée de façon à pouvoir se déplacer dans un plan horizontal X-Y.

6.  Dispositif selon au moins une des précédentes revendications 3 à 5, caractérisé en ce que l'unité de tête de montage (1) peut être déplacée dans la direction de l'axe X par l'intermédiaire d'un servomoteur (3) ayant des moyens de détection de position (4) qui lui sont associés et en ce que l'unité de tête (1) peut être déplacée dans la direction de l'axe Y par l'intermédiaire de son servomoteur (9) ayant des moyens de détection de position (13) qui lui sont associés, lesdits servomoteurs (3, 9) et moyens de détection de position associés (4, 13) étant électriquement connectés à des moyens de contrôle et d'entraînement des axes (6) de l'unité principale de commande (5).

7.  Dispositif selon au moins une des précédentes revendications 3 à 6, caractérisé en ce que la buse d'attraction (14) est supportée de façon pivotante sur l'unité de tête de montage (1) par l'intermédiaire d'un servomoteur (15) d'axe R et est supportée de façon coulissante pour pouvoir coulisser verticalement le long de l'axe Z par l'intermédiaire d'un servomoteur (16) d'axe Z, avec des moyens de détection de position respectifs (17, 18) associés aux servomoteurs (15, 16), lesdits servomoteurs (15, 16) et lesdits moyens de détection de position (17, 18) étant électriquement connectés aux moyens de contrôle et d'entraînement des axes (6) de l'unité principale de commande (5).

8.  Dispositif selon au moins une des précédentes revendications 3 à 7, caractérisé en ce qu'une unité de faisceaux laser (20) est installée, à titre de moyens de détection optique, à une extrémité inférieure de l'unité de tête de montage (1), ladite unité de faisceaux laser (20) comprenant un générateur de faisceaux laser (20A) et un détecteur (20B) disposés l'un face à l'autre de part et d'autre de la buse d'attraction (14).

9.  Dispositif selon au moins une des précédentes revendications 3 à 8, caractérisé en ce que l'unité de faisceaux laser (20) est électriquement connectée à un processeur d'unité laser (21) qui est connecté à un processeur principal (23) par des moyens d'entrées/sorties (22) de l'unité principale de commande (5) .

10. Dispositif selon au moins une des précédentes revendications 3 à 9, caractérisé en ce que l'unité de tête de montage (1) comprend des moyens de détection de position d'interférence (24) qui sont adaptés pour détecter une position d'interférence de l'unité d'approvisionnement de composants (30) et de la buse d'attraction (14), lesdits moyens de détection de position d'interférence (24) étant connectés aux moyens d'entrées/sorties (22) de l'unité principale de commande (5).

11. Dispositif de montage d'un composant (120) à une position spécifique, de préférence sur un substrat tel qu'une carte de circuits imprimés, comprenant une unité de tête de montage mobile (105) supportant au moins une buse d'attraction (121) pour attirer par aspiration au moins un composant (120) à monter à partir d'une section distributrice de composants (104) d'une unité d'approvisionnement de composants, des moyens de détection de position des composants (127) et une unité principale de commande (130) pour contrôler le fonctionnement du dispositif, dans lequel au moins une desdites buses d'attraction (121) est supportée de façon pivotante autour de son axe central vertical (R) et les moyens de détection sont des moyens de détection optique (20) pour produire une projection du composant (120) et pour détecter la largeur de projection (W) du composant (120) ainsi que pour obtenir des valeurs de correction de position de montage ($Y_c$, $\theta_c$), caractérisé en ce qu'au moins une section distributrice de composants (104) et les moyens de détection optique (127) sont disposés de telle façon qu'une direction de diffusion des rayons lumineux des moyens de détection optique (127) définisse un angle prédéterminé (a) d'inclinaison par rapport à la direction de la disposition des composants (120) dans la section distributrice de composants (104).

12. Dispositif selon la revendication 11, caractérisé en ce que l'unité de tête de montage (105) supporte de manière pivotante et coulissante une pluralité de buses d'attraction (121) tandis qu'une pluralité de sections distributrices de composants (104) composées d'une pluralité de rangées de membres distributeurs de composants (104a) est prévue, dans lequel une direction de répartition des buses d'attraction (121) et la direction d'irradiation des rayons lumineux s'étendent de façon inclinée l'une par rapport à l'autre de façon à placer chaque composant (120) dans une position inclinée dans une certaine direction par rapport à la direction des faisceaux lumineux, tandis que les directions de répartition des buses d'attraction (121) et les extrémités de sortie (104b) des membres distributeurs de composants (104b) correspondent entre elles.

13. Dispositif selon les revendications 11 ou 12, caractérisé en ce que les moyens de détection optique (127) comprennent une portion génératrice de faisceaux laser (127a) émettant des faisceaux laser en rayons parallèles, parallèlement à la direction de l'axe X, tandis que la section distributrice de composants (104) est disposée pour aligner une pluralité de bandes distributrices (104a) inclinées (en coupe horizontale) par rapport à un axe Y selon l'angle prédéterminé ($\alpha$).

14. Dispositif selon la revendication 13, caractérisé en ce que ledit angle ($\alpha$) correspond à une plage d'erreur de l'angle de rotation du composant (20).

15. Dispositif selon au moins une des précédentes revendications 11 à 14, caractérisé en ce que lesdits composants comprennent des composants de puce (120) disposés sur la bande distributrice (104a) de telle façon qu'une longueur du composant de puce (120) s'étende de façon globalement perpendiculaire par rapport à la direction de la bande distributrice.

Fig.1

Fig.2

Fig. 3

Fig. 4

**START**

STEP1
PRODUCING VACUUM
FOR ATTRACTION

STEP2
X-,Y-,θ-AXIS START
TO MOVE.

STEP3
(X, Y, θ)
WITHIN PREDETERMINED
POSITIONAL RANGE ? — NO

STEP4 — YES
NOZZLE LOWERED

STEP5
ATTRACTING
COMPONENT

STEP6
NOZZLE RAISED

STEP7
attracting nozzle escaped out
of attracting nozzle
interference range? — NO

STEP8 — YES
attracting nozzle starts
preliminary rotation, head unit
moves to mounting position

STEP9
attracting nozzle raised to
recognizing height and preliminary
rotation completed? — NO

STEP10 — YES
DETECTING $C_s, W_s, \theta_s$

STEP11
NOZZLE ROTATED,
DETECTING MIN. PROJECTION
LENGTH OF COMPONENT

**A**

**A**

STEP12
NOZZLE ROTATED BY $\theta_e$ ? — NO

— YES   STEP13
DETECTING $C_{min}, W_{min}, \theta_{min}$

STEP14
COMPONENT ATTRACTED
CORRECTLY? — NO

— YES

STEP15
COMPONENT
DISCARDED

STEP16
COMPUTING CORRECTION AMOUNT
OF $X_c, Y_c, \theta_c$

STEP17
HEAD UNIT MOVES TO THE
MOUNTING POSITION
AFTER CORRECTED

STEP18
CENTER COORDINATE(X,Y,θ) OF
COMPONENT, WITHIN THE RANGE
FOR MOUNTING? — NO

— YES   STEP19
NOZZLE LOWERED

STEP20
NOZZLE HEIGHT
WITHIN PREDETERMINED
HEIGHT? — NO

— YES   STEP21
VACUUM SUPPLY
STOPPED

STEP22
NOZZLE RAISED .

**E N D**   STEP23

Fig.5

| | UP/DOWN MOVEMENT IN Z-AXIS | ROTATION MOVEMENT IN R-AXIS |
|---|---|---|
| ① | | |
| ② | | |
| ③ | | |
| ④ | | |
| ⑤ | | |
| ⑥ | | |

Fig.6

Fig.7

(a)

(b)

(c)

Fig.8

EP 0 582 086 B2

angle when attracted 0°

$C_S$

$C_{min}$

$W_S$

$W_{min}$

20B

$\theta_S$

$\theta_{min}$

K

b G

a

B

A

O

$C_N$

$Y_{ab}$

$C_N - C_{min}$

$Y_{a0}$

$C_N - C_S$

20A

Y

$\theta$

X

Fig. 9

Fig.10

(a)          (b)          (c)

Fig. 11

Fig. 12

Fig. 13

EP 0 582 086 B2

HEAD UNIT

Fig. 14

first nozzle — position detecting means 125 — R axis servomotor 124
position detecting means 123 — Z axis servomotor 122
second nozzle — position detecting means 125 — R axis servomotor 124
position detecting means 123 — Z axis servomotor 122
third nozzle — position detecting means 125 — R axis servomotor 124, 128
position detecting means 123 — Z axis servomotor 122

position detecting means — X axis servomotor 115
position detecting means 116, 105 — Y axis servomotor 109
101

main controller
axis controller 130, 131

laser unit processer 127
laser unit

interference position detecting means 126

input-output means 132
main processor 133

29

Fig. 15

LASER BEAM

Fig. 16

Fig. 17

Fig. 18

Fig. 19

Fig. 20

EP 0 582 086 B2

Fig. 21